# EUROPEAN PATENT SPECIFICATION

(11) **EP 2 132 148 B1**
(45) Date of publication and mention of the grant of the patent: **19.06.2019**
(21) Application number: 08726163.2
(22) Date of filing: 27.02.2008
(51) Int. Cl.: C03B 23/203, C03B 11/08, B81C 99/00

(54) **METHOD FOR MAKING MICROFLUID DEVICES**
VERFAHREN ZUR HERSTELLUNG VON MIKROFLUIDVORRICHTUNGEN
PROCÉDÉ DE FABRICATION DE DISPOSITIFS MICROFLUIDIQUES

(30) Priority: 28.02.2007 EP 07300835
(43) Date of publication of application: 16.12.2009
(73) Proprietor: Corning Incorporated, Corning, New York 14831 (US)
(72) Inventor: DANNOUX, Thierry, L., F-77210 Avon (FR); MARQUES, Gaspar, P., F-77300 Fountainbleau (FR); MORENA, Robert, M., Lindley, NY 14858 (US); TANNER, Cameron, W., Horseheads, NY 14845 (US)
(74) Representative: Cabinet Beau de Loménie
(86) International application number: PCT/US2008/002584
(87) International publication number: WO 2008/106160

(56) References cited:
- JP-A- 2001 348 243
- JP-A- 2002 097 030
- JP-A- 2003 020 235
- JP-A- 2003 275 575
- US-A1- 2003 192 587
- US-B1- 6 951 119

## Description

### BACKGROUND

Microfluidic devices as herein understood are devices containing fluidic passages or chambers having typically at least one and generally more dimensions in the sub-millimeter to millimeters range. Partly because of their characteristically low total process fluid volumes and characteristically high surface to volume ratios, microfluidic devices can be useful to perform difficult, dangerous, or even otherwise impossible chemical reactions and processes in a safe, efficient, and environmentally-friendly way, and at throughput rates that may be on the order of 100ml/minute of continuous flow or significantly higher.

Microfluidic devices have been made of various materials including metals, ceramics, silicon, and polymers. The shortcomings encountered with these materials are numerous.

For example, devices made of polymers typically cannot withstand temperatures of more than 200°C to 300°C over a prolonged period. Moreover, it is often difficult to control surface states effectively within such structures.

Silicon devices are expensive and incompatible with certain chemical or biological fluids. Further, the semiconductive nature of silicon gives rise to problems with implementing certain pumping techniques, such as electro-hydrodynamic pumping and electro-osmotic pumping. Still further, the lithographic techniques used in forming silicon microfluidic devices naturally produce small channels (typically less than 100 µm). Such small channels have high backpressures and have difficulty achieving production throughput requirements.

Devices made of metal are liable to corrode and are typically not compatible with certain chemical or biological fluids.

It is therefore desirable, in numerous contexts, to have microfluidic structures made of glass, or at least having reaction channels lined with glass.

Microfluidic devices made of glass have been obtained by chemical or physical etching. Etching may be used to produce trenches in a glass substrate which trenches may be sealed by a glass lid, for example. Such techniques are not entirely satisfactory, however. Isotropic chemical etching does not enable significant aspect ratios to be obtained, while physical etching is difficult to implement due to its high cost and limited production capacity. To close the open trenches, the technique most often employed to attach or seal a lid is ionic attachment. This technique, however, is expensive and difficult to implement insofar as it is highly sensitive to dust. Moreover, the surface of each layer must be extremely flat in order to provide high quality sealing.

Microfluidic devices formed of structured consolidated frit defining recesses or passages between two or more substrates have been developed in previous work by the present inventors and/or their associates, as disclosed for example in U.S. Patent No. 6,769,444, "Microfluidic Device and Manufacture Thereof. Methods disclosed therein include various steps including providing a first substrate, providing a second substrate, forming a first frit structure on a facing surface of said first substrate, forming a second frit structure on a facing surface of said second substrate (two forming methods are described: one comprising applying a mold made of elastomer on a mixture (glass frit (for example) + organic binder), the other comprising injecting a mixture (glass frit (for example) + organic binder) into a mold), presintering and consolidating said first substrate and said second substrate and said first and second frit structures together, with facing surfaces toward each other, so as to form one or more consolidated-frit-defined recesses or passages between said first and second substrates. In devices of this type, because the consolidated frit defines the fluidic passages, the passages can be lined with the glass or glass-ceramic material of the consolidated frit, even if a non-glass substrate is used.

Another approach to making glass microfluidic devices, disclosed for example in International Patent Publication WO 03/086958 involves vapor deposition of the glass on a surface of a temporary substrate that is shaped to serve as a negative mold for the shape to be produced. After glass is formed on the surface by vapor deposition, the temporary substrate is removed from the glass by wet etching. Vapor deposition and etching are relatively slow, expensive and environmentally unfriendly processes.

The present inventors and/or their associates have developed a method of forming a microfluidic device in which a thin sheet of glass is vacuum-formed resulting in an alternating channel structure on opposing sides of the sheet, then closed by fusing with one or more other vacuum-formed or flat sheets, as shown for example in US Patent Publication 2005/0241815. While the method therein disclosed is useful for the purposes described therein, it is desirable to be able to form even finer and more complex structures than is possible with this vacuum-forming technique, including sharp groove angles (*e.g.,* 90°) and a larger variety of channel shapes and sizes.

Another approach of making microfluidic devices is also disclosed in JP 2003-275575.

### SUMMARY

Described herein are methods of producing microfluidic devices. The advantages of the materials, methods, and devices described herein will be set forth in part in the description which follows, or may be learned by practice of the aspects described below. The advantages described below will be realized and attained by means of the elements and combinations particularly pointed out in the appended claims.

### BRIEF DESCRIPTION OF FIGURES

Figure 1 shows stacked system for forming a composition comprising a glass into a formed article.
Figure 2 shows multiple stacked systems being processed through an oven via a conveyor belt.
Figure 3 shows a cross-section of a composition comprising glass disposed between the surfaces of first and second structures after the start of thermal processing.
Figure 4 shows the cross-section of a composition comprising glass disposed between first and second structures, where a surface of one of the structures has penetrated the composition.
Figure 5 shows the cross-section of a formed glass-containing composition removed from the molding surface and a release angle of a mold impression.
Figure 6 shows the cross-section of an amount of a glass-containing composition disposed between two different molding surfaces to produce a formed article with mold impressions on both sides.
Figure 7 shows a glass sheet with four molding surface impressions on one side of the sheet.
Figure 8 shows a stacked system composed of multiple amounts of a composition comprising glass disposed between respective multiple structures having patterned surfaces.
Figure 9 is a photograph of a structure 3 in the form of a porous graphite structure illustrative of certain embodiments of the present invention.
Figure 10 is a photograph of a porous graphite structure and a formed glass sheet produced therefrom.
Figure 11 is a photograph of a formed glass sheet.
Figure 12 is a photograph of a sample microfluidic device assembled by pressing two formed glass sheets together, where the grey channels are open recesses in the device.
Figure 13 shows a photograph of formed glass sheet pressed and fused onto a silicon wafer.
Figure 14 shows a cross-section of a composition comprising glass disposed between a molding surface and a second surface, the second surface comprising a surface of a substrate 100 to which the glass composition will be adhered.
Figure 15 shows a cross-section of a composition comprising glass disposed between a molding surface and a second surface, the second surface comprising a surface of a substrate 100 to which the glass composition will be adhered or a surface of a structure comprising a rigid, non-stick material, wherein one or more mold inserts 102, 103 are positioned on or in the surfaces 12, 14.
Figure 16 shows a cross-section of a formed article 51 having one or more inserts 102, 103 incorporated therein.
Figure 17 shows a cross section of a two amounts of compositions comprising glass each disposed between a respective molding surface and a second surface, the second surface comprising a surface of a substrate 100 to which the glass composition will be adhered.

### DETAILED DESCRIPTION

In one aspect, the method for making a glass-containing microfluidic device comprises: providing a first piece having a patterned molding surface; providing a first amount of glass-containing composition; contacting the first amount of glass-containing composition with the patterned molding surface; pressing the first amount of glass-containing composition between the patterned molding surface and a second surface; heating the first piece and the first amount of glass-containing composition together sufficiently to soften the amount of glass-containing composition such that the patterned molding surface is replicated in the first amount of glass-containing composition, the first amount of glass-containing composition forming a first formed glass-containing article; and sealing at least a portion of the first formed glass-containing article to create a microfluidic device having at least one fluidic passage therethrough. Characteristically, said first piece is of a rigid, non-stick material, the step of heating together comprises heating to a temperature sufficient to produce molten glass and result in viscous flow of the glass-containing composition and the second surface comprises a surface of a substrate onto which the glass-containing composition is to be formed, said heating step being effective to attach or join the glass-containing composition to the surface of the substrate.

The glass-containing material useful herein is any glass-containing material that upon heating can be converted to a viscous material. The glass-containing material may be in the form of a frit, including a filled frit. The glass-containing material may also be in the form of a sheet. The dimensions of the sheet can vary from few hundred square microns up to several decimeters square and have sheet thicknesses from several hundred micrometers up to several centimeters. The glass containing material may comprise vitreous glass, glass ceramic, or a glass composite. While silica glasses are presently preferred, the methods of the present invention can also include the use of other glass network formers, such as Ge, Al, B, P, and so forth.

The glass composite may comprise a glass frit and a filler. The composite may be prepared, in frit form, by intimately admixing a glass frit and a filler. The resulting frit composite or filled frit may then be used directly as the glass-containing material, in the forming methods of the present invention, or it may first be formed into a glass sheet or other structure. In either case, it is desirable that the filler is evenly dispersed or integrated throughout the composite. This helps ensure that the entire glass sheet has reasonably consistent properties (*e.g.,* average thermal conductivity) throughout the entire sheet. Certain glass frit and filler materials useful herein will be described below.

The glass frit is any glass material that upon heating can be converted to a viscous material. A variety of materials can be used herein. In one aspect, the glass frit comprises SiO₂ and at least one other alkaline oxide, alkaline earth oxide, a transition metal oxide, a non-metal oxide (*e.g.,* oxides of aluminum or phosphorous), or a combination thereof. In another aspect, the glass frit comprises an alkaline silicate, an alkaline earth silicate, or a combination thereof. Examples of materials useful as glass frits include, but are not limited to, a borosilicate, zirconium-containing borosilicate, or sodium borosilicate.

Turning to the filler, the filler is desirably nearly or completely inert with respect to the glass frit in order to preserve the thermal and mechanical properties of the filler. When the filler is nearly or completely inert with respect to the glass frit, the filler has no or minimal reaction within the filler/frit matrix such that there is essentially no foaming, forming of new phases, cracking and any other processes interfering with consolidation. Under these conditions, it is possible to produce a composite with minimal porosity.

The filler is also generally desirably non-porous or has minimal porosity and possesses low surface area. The filler does not burn out during sintering like organic compounds typically used in the art. The filler can remain rigid, soften, or even melt during thermal processing. In one aspect, the filler has a softening or melting point greater than that of the glass frit. Depending upon the selection of the filler, the filler can form an oxide, which will facilitate its integration into the final composite.

The filler desirably increases the average thermal conductivity of the composite. In one aspect, the filler has an average thermal conductivity greater than or equal to 2 W/m/K, greater than or equal to 3 W/m/K, greater than or equal to 4 W/m/K, or greater than or equal to 5 W/m/K. Examples of fillers useful herein include, but are not limited to, silicon carbide, aluminum nitride, boron carbide, boron nitride, titanium bromide, mullite, alumina, silver, gold, molybdenum, tungsten, carbon, silicon, diamond, nickel, platinum, or any combination thereof.

The amount of filler can vary depending upon, among other things, the type of glass frit selected and the desired average thermal conductivity. In one aspect, the amount of filler is greater than or equal to 5% by volume of the composite. In another aspect, the amount of filler is from 15% to 60% by volume of the composite.

With respect to the material used to make the mold, the porosity and chemical stability of the mold are to be considered in addition to the CTE/Young's modulus of the mold material relative to the glass. With respect to porosity, the mold most desirably possesses a certain degree of porosity so that gases produced during thermal processing can escape the molten glass through the porous mold and not be entrapped in the glass. In one aspect, the mold has an open porosity greater than 5%, that is, greater than 5% of the volume of the mold is open. In another aspect, the mold has a porosity of at least 10%.

Another consideration when selecting the mold material is that the mold should be chemically stable at elevated temperatures, particularly those required to convert the glass sheet to molten glass. The term "chemically stable" as used herein with respect to the mold material is defined as the resistance of the mold material to be converted from an inert material to a material that can interact with the molten glass. For example, while boron nitride could be used, boron nitride can be converted to boron oxide at temperatures greater than 700°C. Boron oxide can chemically interact with glass, which results in the glass sticking to the mold. Thus according to one aspect of the present invention, boron nitride may be used but is not preferred.

More desirably, the mold material comprises carbon, most desirably porous carbon adequately CTE-matched to the glass-containing material, such as grade 2450 PT graphite manufactured by Carbone Lorraine for glasses such as Corning 1737 glass or similar, or such as grade AF5 graphite manufactured by Poco Graphite for use with alumina CTE materials of similar CTE. 2450 PT graphite has a CTE of 25 x10⁻⁷/°C at 300 °C and open porosity level of about 10%. AF5 graphite has a CTE of 72.3 x10⁻⁷/°C at 300 °C and similar open porosity.

Techniques such as CNC machining, diamond ultra high speed machining, electro discharge machining, or a combination thereof can be used to make specific molding surfaces. The molding surface design can vary depending upon the desired features. As will be discussed in detail below, the methods described herein permit the use of molding surfaces with high aspect ratios (height/width greater than 3) and absolute heights from few microns up to several millimeters. Absolute heights and aspect ratios are not restricted to single values and can vary from one area of the molding surface to another. The molding surface can possess a variety of different three-dimensional (3D) grooved structures (*e.g.,* channels, cavities) and raised structures (*e.g.,* walls, pillars), which are desirable in microfluidic devices. Moreover, a release angle of 90° is possible with the grooved or raised structures on the mold, the relevance of which will be described in more detail below.

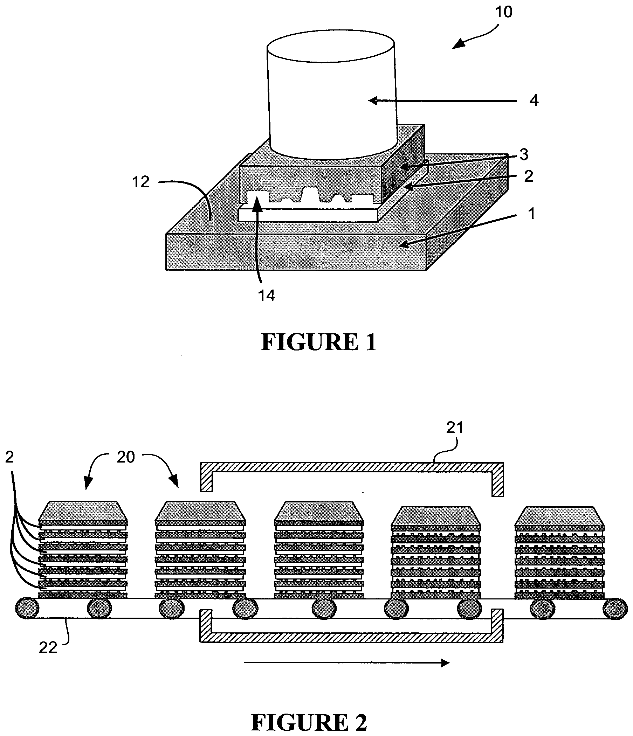

One embodiment for producing formed glass-containing articles will now be described with reference to Figure 1. A first amount of a glass-containing composition, in the form of a sheet 2 in this case, is disposed between a patterned molding surface 14, of a first piece 3 of rigid, non-stick material, and a second surface 12, in this case comprising the flat upper surface of a second piece 1 of rigid, non-stick material. If the glass-containing composition is in the form of a sheet 2, it is generally desirable that the sheet 2 have a high degree of planarity. The patterned surface 14 and the second surface 12 can be composed of the same or different materials. In one aspect, the patterned surface 14 comprises carbon, a boron nitride ceramic, or a combination thereof. In another aspect, when the patterned surface 14 and the second surface 12 are composed of the same material, the material is carbon, desirably porous carbon, such as grade 2450 PT graphite manufactured by Carbone Lorraine, or grade AF5 from Poco Graphite, for instance.

A release agent may optionally be used. The release agent can be applied to any of the second surface 12, the glass-containing composition 2, and the patterned surface 14 as desired. The amount of release agent that may be applied can vary. It is desirable that the material of the patterned surface 14 and release agent have similar properties or that they are composed of similar materials. For example, when the patterned or molding surface 14 is composed of graphite, the release agent is desirably carbon soot.

Pressure is desirably applied to the interface between the glass-containing composition 2 and the patterned surface 14, so as to press the glass-containing composition 2 between the patterned surface 14 and the second surface 12. This may be achieved by a load 4 placed on top of the first piece 3 to facilitate penetration of the patterned surface or molding surface 14 into the glass-containing composition 2 during heating. The second piece 1, the glass-containing composition 2, the first piece 3 and the load 4 together form a stacked system 10. The load can be prepared from any material that can withstand elevated temperatures (*i.e.,* temperatures required to adequately soften the glass-containing composition 2). The weight of the load can vary depending upon the amount or thickness of the glass-containing composition 2 and the desired amount of penetration of the patterned surface 14 into the composition 2. The required pressure may also be applied in other ways, such as actively applied by means of a piston, in which case no load would be required in the stacked system 10, and the pressure may be applied after heating has begun, if desired.

Once the stacked system 10 composed of the first piece, the glass-containing composition, the second piece, and the optional load is prepared, the stacked system 10 is heated to a temperature sufficient to result in viscous flow of the glass-containing composition 2. To perform this heating, the stacked system 10 can be placed in an oven. Prior to heating, air in the oven is desirably removed by vacuum, and an inert gas such as nitrogen is introduced into the oven. It is contemplated that one or more stacked systems can be introduced into the oven.

A series of stacked systems can be introduced into the oven by way of a conveyor belt, and the stacked systems can include more than one amount of glass-containing composition. This aspect is depicted in Figure 2, where a series of stacked systems 20 are fed into the oven 21 under an atmosphere of nitrogen gas by a conveyor belt 22, and where each stacked system 20 includes six amounts 2 of the glass-containing composition. The rate at which the stacked systems 20 are transitioned into the oven can vary from one minute to one hour. The process depicted in Figure 2 is an efficient method for producing a large number of formed articles from the multiple starting amounts 2 of the glass-containing compositions. For example, if stacked systems composed of amounts 2 are fed into the oven at 5meters/hr for a two hour thermal cycle, and the oven is 12 m long, the oven can thermally process 60 stacked systems per hour, which corresponds to 600 formed articles produced in one hour.

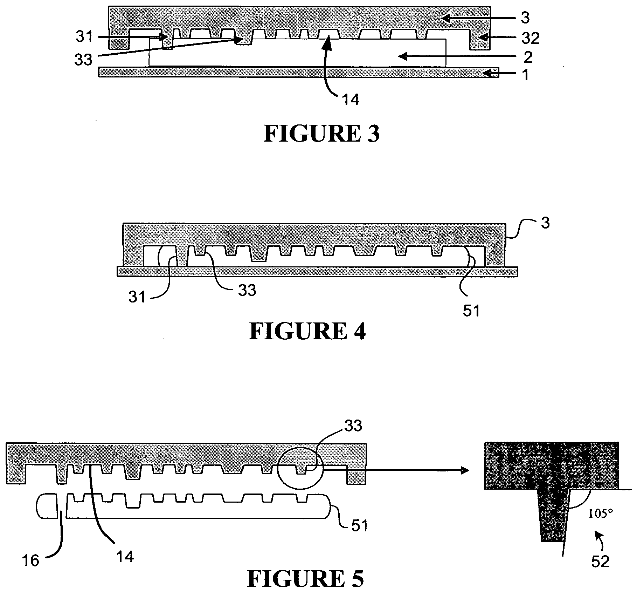

Figure 3 shows a cross-sectional view of a stacked system 10 without the load. With respect to first piece 3, the patterned or molding surface 14 can have one or more areas or features 31 of the surface 14 that contact the second surface of the second piece when the forming of the article 51 is complete, as shown in Figure 4. The area or feature 31, in the form of an area spaced apart from the perimeter of the patterned surface 14 in this case, is offset enough from the majority of the surface 14 in the vertical direction in the Figures such that it can penetrate the glass-containing composition 2 upon thermal processing, and produce a through-hole 16 in the formed article 51, as shown in Figure 5. The shape of the area 31 can be any shape such as round, rectangular, or oblong. The formation of through-holes during thermal processing avoids hole-drilling in the formed article 51, which can be expensive and damage or destroy the article. As another optional feature of its patterned surface 14, the first piece 3 also has a another area that contacts the second surface 12 of the second structure when forming is complete, area 32 at the perimeter of the patterned surface 14, and optionally surrounding the patterned second surface 14 of the first piece 3. Such a surrounding raised area can act as a flow retainer to prevent molten glass from escaping from between the pieces 1 and 3. Such a flow retainer can also help ensure uniform thickness and homogeneity of the glass during processing.

As shown in Figure 3, a plurality of raised areas 33 are on surface 14 of first piece 3, which ultimately produce the formed features in the glass-containing composition. Referring to Figure 4, upon heating, the glass-containing composition is converted to a softened or viscous state, at which time the area 31 and areas 33 penetrate the glass-containing composition. Figure 5 shows the formed article 51 after processing and removal from the surface 14.

The temperature and duration of thermal processing of the stacked system 10 or 20 can vary among several parameters including, but not limited to, the viscosity of the glass-containing composition, the aspect ratio of the surface 14, and the complexity of the surface 14. Typical techniques for making glass molding surfaces are limited to short heating times in order to avoid sticking of the molten glass to the surface. This results in the formation of simple molding surfaces. The methods described herein avoid sticking of the molten glass to the molding surface during processing. Thus, longer heating times are possible with the methods described herein, which permit the softened glass-containing composition to penetrate each opening of an intricate molding surface. This ultimately results in the formation of more intricate formed glass-containing articles. Thus, the stacked system can be heated from one minute to one hour or even longer, which is a much broader range than typical hot forming techniques.

After the heating step, the stacked system is allowed to slowly cool down to at least 100° C, and desirably all the way to room temperature over time. The methods described herein not only prevent the softened glass-containing composition from sticking to the molding surface or surfaces, the methods described herein permit slow cooling of the glass-containing composition and the molding surface together, without the glass freezing (*i.e.,* sticking) to the molding surface. By cooling slowly, the formation of cracks in the first piece 3 and the patterned surface 14 can be prevented, such that the first piece 3 and its patterned or molding surface 14 may be re-used. Moreover, because the patterned surface 14 does not stick to the formed article 51, the first piece 3 and its patterned surface 14 can be removed from the formed article by hand, and not by techniques commonly used in the art such as etching. This has a dramatic positive effect on total production cost and the overall quality of the formed article.

As described above, the methods described herein permit the production of formed glass-containing articles with intricate and detailed features. For example, the molding surface can possess a plurality of areas that can penetrate the glass-containing composition at a depth of greater than 100 µm and a width greater than 100 µm. In another aspect, the depth can be from of 100 µm to 10 mm and the widths can be from 100 µm to 10 mm. In another aspect, the molding surface has an aspect ratio greater than three, where the aspect ratio is the height of the area or feature of the surface 14 (in the vertical direction in the Figures) over the width of the area or feature. Referring to Figure 5, a release angle 52, in one experiment was 105°. Release angles of exactly 90° are generally not possible using previously known techniques due to the glass-containing composition sticking to the molding surface. But because the methods described herein avoid sticking between the glass-containing composition and the molding surface, release angles close to 90° are possible. Moreover, high aspect ratios coupled with release angles approaching 90° are also possible. Once again, because the softened glass-containing composition does not stick to the molding surface, longer heating times are possible, which results in increased aspect ratios and in release angles approaching 90°. This can be desirable in certain applications such as microfluidic devices.

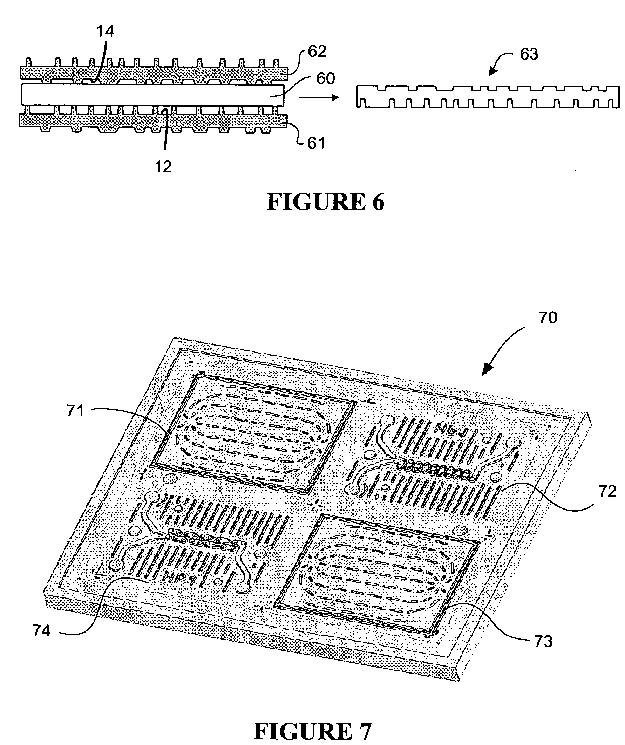

Although the second surface 12 of the second piece 1 in Figure 1 is planar, the second surface 12 alternatively can also be a patterned surface. Referring to Figure 6, glass-containing composition 60 is inserted between a first piece 62 and a second piece 61. In this aspect, first and second surfaces 14 and 12 of first and second pieces 62 and 61 are both patterned, and are different but complementary to each other with respect to the number and dimensions of raised areas. After thermal processing, a formed glass-containing article 63 is produced where each side of the article has molding-surface impressions. Thus, it is possible to have the same or different impressions on each side of the formed glass-containing article.

In another aspect, two or more first or second pieces may be disposed on the same surface of the glass-containing composition, wherein the pieces comprise identical or different patterned surfaces. In Figure 7, a formed glass-containing article 70 has been formed by four first pieces, with the resulting formed patterns 71 and 73 being the same and the resulting formed patterns 72 and 74 being the same. Depending upon the lateral extent of the particular amount of glass-containing composition and the one or more pieces used to pattern it, it is possible to place several pieces, each with a patterned or molding surface, side-by-side on the surface of the glass-containing composition and subject the resulting stack to thermal processing.

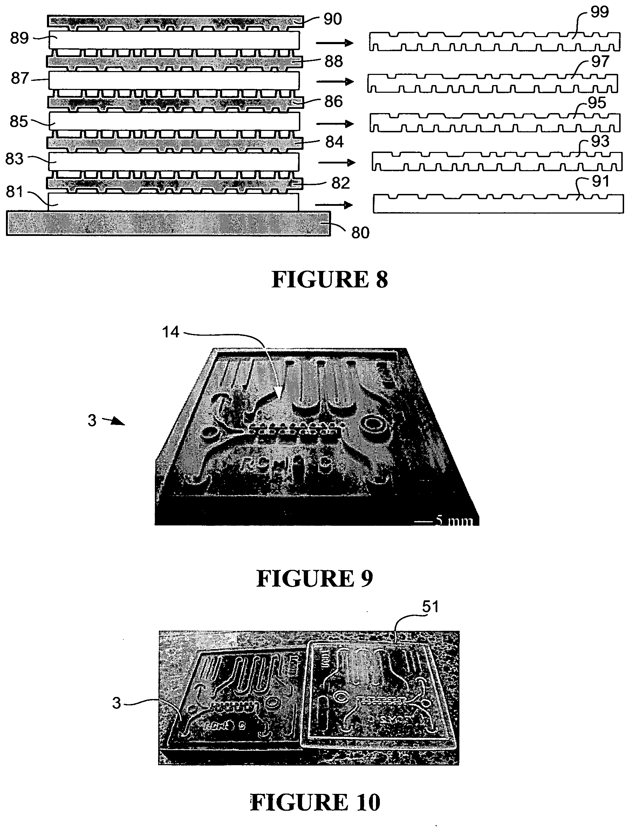

The techniques described above are also useful in making a plurality (*i.e.,* two or more) formed glass-containing articles simultaneously. Referring to Figure 8, amounts of glass-containing composition 81, 83, 85, 87, and 89 are disposed or sandwiched between the piece 80 and pieces 82, 84, 86, 88, and 90. In the case of pieces 82, 84, 86, and 88, there are two patterned surfaces on each. Thus, a plurality of formed glass-containing articles can be produced from one stacked system. As shown in Figure 8, five formed articles 91, 93, 95, 97, 99 are produced after thermal processing and removal of the formed articles. It is possible to produce a large number of formed articles in a short period of time. Although structures 82, 84, 86, and 88 each have the same two patterned surfaces, it is contemplated that structures having more than two different surfaces can be stacked similarly to produce a plurality of different formed articles simultaneously.

The formed glass-containing articles produced by the methods described herein are useful in the production of microfluidic devices such as microreactors. Microreactors may be formed from the formed articles by sealing at least a portion of a formed article to create at least one fluidic passage. One way such sealing may be achieved is by stacking multiple formed articles having cooperating facing structures, with or without a sealing promoting agent such as a frit, then sealing the stacked structure at elevated temperature in air. The atmosphere employed and the temperature and duration of heating will vary depending upon the material used to make the formed articles. The duration of heating is long enough to ensure that a complete seal is formed between each of the contacting formed articles. In the case of microreactors, this is important so that no reactants leak from the system as well as to maintain internal pressure within the microreactor. Other sealing methods include sealing with polymer materials such as polymer adhesives, even with a polymer substrate if desired, sealing with inorganic binders, sealing chemical fusion or chemically assisted fusion and so forth.

Where glass is the principal material of the final device, because both sides of the formed articles can be structured, and structured to some degree independently of the other, this method minimizes the number of glass components needed to make a glass microfluidic device or microreactor, particularly a glass microreactor with multiple layers.

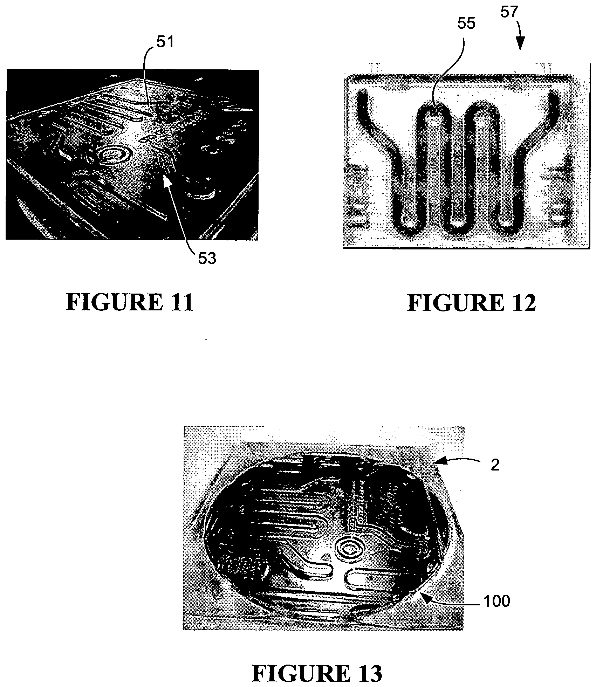

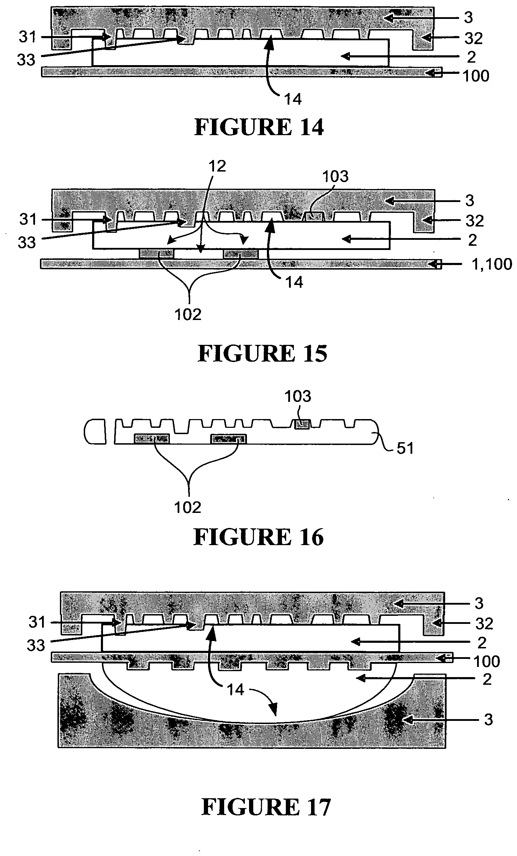

In other aspects, it may be desirable to attach a formed glass-containing article to a substrate that is not glass. For example, a formed glass-containing sheet sealed to a high thermal conductivity substrate can improve heat transfer of the resulting microreactor. In one aspect, the material used for the substrate has a CTE similar to that of the glass-containing composition to be formed and can withstand the processing temperature. Examples of substrates useful herein include, but are not limited to silicon, silicon carbide, alumina, and similar materials. Use of high-thermal conductivity substrates can increase the thermal performance of microfluidic devices formed according to the methods of the present invention. So, according to the present invention, the second surface 12 comprises a surface of a substrate 100 onto which the glass-containing composition is to be formed, as shown in the cross-section of Figure 14. The heating step is then effective to attach or join the glass-containing composition to the surface of the substrate. Figure 13 is a perspective-view photograph of a glass-containing composition 2 formed onto a silicon wafer 100 in this manner, resulting in a formed article comprising both glass and the material of substrate 100, silicon in this case.

Referring to Figure 15, the second surface 12 against which the glass-containing composition is pressed may further comprises one or more surfaces of one or more a mold inserts 102, 103 placed either on said second piece 1 of rigid, non-stick material or on said substrate 100. Inserts may also be placed on or in the patterned surface of first piece 3, for incorporation into the resulting formed glass-containing article 51, as shown in Figure 16.

Referring to Figure 17, the disclosed process may also be employed to form two separate amounts of glass-containing compositions 2 on both sides of a substrate 100, desirably simultaneously. As may be seen from the lower of the two pieces 3 with patterned surfaces 14, the patterns may have non-planar geometries as well, and the substrate 100 may be non-planar also.

### EXPERIMENTAL

### Fabrication of Patterned (Molding) Surface(s)

Fabrication of a patterned surface such as that shown in Figure 9, for example, was achieved by CNC machining from a piece of graphite block (grades used have included C25 and 2450 PT from Carbone Lorraine, of Gennevilliers, France and AF5 from Poco Graphite of Decatur, Texas USA). C25 has a thermal expansion of 33 x 10⁻⁷/°C at 300 °C and an open porosity level of about 10%, which allows gas to escape the glass during processing and prevent bubble formation. The patterned surface 14 design in Figure 9 is representative of structures used in microreactors. Here, feature heights of the mold vary from 100 µm to 1.5 mm and widths vary from 100µm to 7 mm. Referring to Figure 9, the mold includes a serpentine structure (height = 1 mm, width = 4 mm), a multipart structure that corresponds to the mixer zone, and some pillars of various aspect ratio, and some concentric circles.

### Preparation of Molded Glass Sheet

Referring to Figure 1, a first piece 3 of rigid, non-stick material, having a first patterned surface 14 as shown in Figure 9, was placed on a glass-containing composition 2 in the form of a sheet of Borofloat™ glass. The glass sheet was supported below by a second surface 12 of a second piece 1. The first and second pieces were both formed of carbon. A load 4 in the form of a metal weight machined from AISI 310 refractory metal was placed on top of the first piece 3 to increase the rate of penetration of the features or areas of the patterned surface 14 into the glass-containing composition during heating. The mass and diameter of the weight were 1.5 kg and 100 mm. One particular value of the present process is that large pressures are not require, such that a gravity and a simple weight can provide good results. In particular, it is desirable that the pressure between the molding surface and the glass-containing composition be less than 100kPa, desirably less than 10 or even 1kPa.

The stacked assembly 10 was loaded into an oven and heated under nitrogen flowing. Prior to introducing nitrogen, air in the oven was removed by vacuum. The temperature of the furnace was increased up to 900 °C over two hours to induce viscous deformation of the glass sheet into the recesses of the surface 14. There was a one-hour dwell followed by cooling down to room temperature over five hours. The first and second pieces and the formed glass sheet were disassembled by hand. Figures 10 and 11 show the formed Borofloat glass sheet (3.5 mm thick at start) formed by the procedure described above. All features of the molding surface, even the most intricate features, were replicated on the surface of the glass. Moreover, as may be seen from Figure 11, even mold machining defects 53 on the mold caused by the action of the tool of the CNC equipment were replicated onto the surface of glass sheet.

### Assembly of a Microfluidic Device

In order to make a microfluidic component, two formed glass sheets produced by the procedure above were sealed together at 800 °C in air. Referring to Figure 12, the fluidic passage 55 in the form of a serpentine channel feature (dark shade, produced by colored fluid in the channel) formed in the resulting device 57 has a height of 2 mm and a width of 4 mm. This assembly sustained a pressurization value of about 60 bars. No weakness of seal interface was observed.

One particular value for microfluidic devices is found in assembling three or more of the formed articles produced according to the steps herein particularly if all through-holes are formed as a part of the initial forming process. For example, formed structures 91, 93, 95, 97 and 99 can be stacked and sealed together to form a multiple layer microfluidic device.

### Other Non-Glass Substrates-Glass/Alumina Microreactor

A first piece having a structured or molding surface was machined into AF5 Graphite (POCO Inc), (CTE at 300°C of 72.3x 10-7/°C). A substrate 100 of AD-96 Alumina AD-96 (COORSTEK Inc) (CTE at 300°C of 68.0x 10-7/°C) was employed together with a glass material having a CTE at 300°C of 63.4x 10-7/°C, and a working point (104 Po)= 1156°C. The glass composition used is set forth below in Table 1.

### PROCESS DESCRIPTION:

A preliminary test was performed to assess expansion compatibility of Graphite AF5 and the glass composition of Table 1 through a pressing trial. For this test, a glass sheet (165 x 135 x 2.25 mm) was pressed on both sides in between two patterned surfaces. Pressing temperature was 1025°C (glass viscosity ∼105 Po), and pressing time was 1 hour. The applied load was 5kg over a 131x161 mm surface. Removal of the formed article 51 from the patterned surfaces of the molds was very easy. This indicates acceptable expansion match of the glass of Table I and AF5.

The stiffness provided by the alumina layer seemed to especially facilitate removal from the mold without glass breakage.

A second test was performed to form a glass sheet directly onto an alumina substrate. An alumina substrate (161 x 131 x 1 mm) and a glass sheet (165 x 135 x 2.25mm) and a patterned molding surface were all provided, of material composition as described above. The alumina and glass sheet were washed and cleaned carefully.

The patterned or molding surface was placed with pattern upward, next the glass containing composition, in the form of a glass sheet, and then the alumina substrate were stacked, followed by a graphite block and 5 kg of weight. To prevent air from being trapped in between the glass and the alumina substrate, heating was performed under vacuum of 20 mbar until reaching a plateau at 1025°C. Then the furnace was re-pressurized with nitrogen until end of the thermal cycle.

After cooling, the stack was disassembled. No particular difficulty was encountered during disassembly. All pattern features were perfectly replicated (channel depth of about 450-470 µm). The backside of the alumina substrate was flat, indicating that CTE and final size mismatch is relatively low, as residual stress does not induce any warpage or camber. However, the thickness of residual glass layer below the channel (above the alumina) was about 1.8 mm which is larger than preferred for optimal heat exchange capability.

As a third test, beginning with a glass sheet of 1mm thickness under similar conditions, residual glass layer below the channel was measured at 700 µm.

As a fourth test, instead of a glass sheet, the glass-containing composition 2 took the form of a layer of glass frit and wax paste on the alumina substrate 100, deposited by flat molding techniques, then pre-sintered at 1000°C in air for 1 hour, leaving a glazed layer of 460-620 µm thickness. A patterned surface was then stacked on this layer, with a load on that of 10 kg, and the stacked assembly was fired for 1h at a temperature of 1025°C in nitrogen atmosphere. No vacuum was employed during the ramp up. Most of the pattern features were completely replicated, except for some defects at the edges and some porosity, indicating that the thickness of the starting layer should probably be more uniform and/or a little greater, and that use of vacuum during heating may be of benefit. Microfluidic devices formed of filled frits, such as alumina-filled frits, and formed onto alumina substrates, are high heat-transfer, highly chemically and thermally resistant microfluidic devices that may be formed by the methods of the present invention.

| Table 1 | |
|---|---|
| Oxide | % mol |
| SiO₂ | 76.5 |
| B₂O₃ | 3.2 |
| Al₂O₃ | 3.0 |
| Na₂O | 14.4 |
| ZrO₂ | 2.9 |

## Claims

1. A method for forming a glass-containing microfluidic device having at least one fluid passage therethrough, the method comprising:
providing a first piece (3; 62; 82) having a patterned molding surface (14);
providing a first amount of glass-containing composition (2; 60; 81);
contacting the first amount of glass-containing composition (2; 60; 81) with the patterned molding surface (14);
pressing the first amount of glass-containing composition (2; 60; 81) between the patterned molding surface (14) and a second surface (12);
heating the first piece (3; 62; 82) and the first amount of glass-containing composition (2; 60; 81) together sufficiently to soften the amount of glass-containing composition (2; 60; 81) such that the patterned molding surface (14) is replicated in the first amount of glass-containing composition (2; 60; 81), the first amount of glass-containing composition (2; 60; 81) forming a first formed glass-containing article (51; 63; 91);
sealing at least a portion of the first formed glass-containing article (51; 63; 91) to create a microfluidic device having at least one fluidic passage therethrough;
**characterized in that** said first piece (3; 62; 82) is of a rigid, non-stick material, **in that** the step of heating together comprises heating to a temperature sufficient to produce molten glass and result in viscous flow of the glass-containing composition (2; 60; 81) and **in that** the second surface (12) comprises a surface of a substrate (100) onto which the glass-containing composition (2) is to be formed, said heating step being effective to attach or join the glass-containing composition (2) to the surface (12) of the substrate (100).

2. The method as claimed in claim 1 wherein the second surface (12) further comprises one or more surfaces of one or more a mold inserts (102) placed on said substrate (100), for incorporation into the resulting formed glass-containing article (51).

3. The method as claimed in either claim 1 or claim 2 wherein one or more inserts (103) are placed on or in the patterned surface (14) of first piece (3), for incorporation into the resulting formed glass-containing article (51).

4. The method as claimed in any of claims 1-3 wherein the second surface (12) is flat or patterned.

5. The method as claimed in any of claims 1-4 wherein either the substrate (100) or at least one of the one or more mold inserts (102; 103) comprises a material having thermal conductivity higher than that of the glass of the glass-containing composition (2).

6. The method as claimed in any of claims 1-5 wherein either the substrate (100) or at least one of the one or more mold inserts (102; 103) comprises one or more of ceramic, silicon, compounds of silicon, and metal.

7. The method as claimed in any of claims 1-6 wherein either the substrate (100) or at least one of the one or more mold inserts (102; 103) comprises alumina.

8. The method as claimed in any of claims 1-7 wherein the first piece (3; 62; 82) of rigid, non-stick material comprises carbon.

9. The method as claimed in any of claims 1-8 wherein the first piece (3; 62; 82) of rigid, non-stick material comprises a porous material with an open porosity of at least 5%, even of at least 10%.

10. The method of any of claims 1-9 wherein the glass-containing composition (2; 60; 81) consists of one or more vitreous glasses or comprises a glass-ceramic.

11. The method of any of claims 1-9 wherein the glass-containing composition (2; 60; 81) comprises a filled glass comprising a glass and at least one filler, and wherein the at least one filler has a higher thermal conductivity than the glass.

12. The method of claim 11 wherein the filler is alumina.

13. The method of any of claims 1-12 wherein the step of providing a first amount of glass-containing composition (2; 60; 81) comprises providing the glass-containing composition in the form of a sheet.

14. The method of any of claims 1-12 wherein the step of providing a first amount of glass-containing composition comprises providing the glass containing composition in the form of a frit or consolidated frit layer.

15. The method of any of claims 1-14 wherein the step of sealing comprises stacking the first formed glass-containing article (91) with one or more additional glass-containing articles or formed glass-containing articles (93; 95; 97; 99) and sealing the stacked articles together.

16. The method of any of claims 1-15 further comprising the step of positioning a release agent between the first amount of glass-containing composition (2; 60; 81) and the patterned surface (14).

## Patentansprüche

1. Verfahren zur Herstellung einer glashaltigen Mikrofluidikvorrichtung, die wenigstens einen sie durchbringenden Fluiddurchlass aufweist, wobei das Verfahren umfasst:
Bereitstellen eines ersten Teils (3; 62; 82) mit einer strukturierten Formgebungsfläche (14),
Bereitstellen einer ersten Menge einer glashaltigen Zusammensetzung (2; 60; 81),
Inkontaktbringen der ersten Menge der glashaltigen Zusammensetzung (2; 60; 81) mit der strukturierten Formgebungsfläche (14),
Pressen der ersten Menge der glashaltigen Zusammensetzung (2; 60; 81) zwischen der strukturierten Formgebungsfläche (14) und einer zweiten Fläche (12),
ausreichendes gemeinsames Erhitzen des ersten Teils (3; 62; 82) und der ersten Menge der glashaltigen Zusammensetzung (2; 60; 81), um die Menge der glashaltigen Zusammensetzung (2; 60; 81) zu erweichen, so dass die strukturierte Formgebungsfläche (14) in der ersten Menge der glashaltigen Zusammensetzung (2; 60; 81) reproduziert wird, wobei die erste Menge der glashaltigen Zusammensetzung (2; 60; 81) einen ersten gebildeten glashaltigen Gegenstand (51; 63; 91) bildet,
Abdichten von mindestens einem Abschnitt des ersten gebildeten glashaltigen Gegenstands (51; 63; 91), um eine Mikrofluidikvorrichtung mit mindestens einem Fluidikdurchlass dort hindurch zu erzeugen,
**dadurch gekennzeichnet, dass** das erste Teil (3; 62; 82) aus einem steifen Antihaftmaterial besteht, dass der Schritt des gemeinsamen Erhitzens ein Erhitzen auf eine Temperatur umfasst, die dazu ausreicht, eine Glasschmelze zu ergeben und zu einem viskosen Fluss der glashaltigen Zusammensetzung (2; 60; 81) zu führen, und dass die zweite Fläche (12) eine Fläche eines Substrats (100) umfasst, auf dem die glashaltige Zusammensetzung (2) gebildet werden soll, wobei der Erhitzungsschritt dazu wirksam ist, die glashaltige Zusammensetzung (2) an der Fläche (12) des Substrats (100) anzufügen oder mit dieser zu verbinden.

2. Verfahren wie in Anspruch 1 beansprucht, wobei die zweite Fläche (12) ferner eine oder mehrere Flächen von einem oder mehreren Formeinsätzen (102), die auf dem Substrat (100) platziert sind, zum Einfügen in den resultierenden gebildeten glashaltigen Gegenstand (51) umfasst.

3. Verfahren wie in einem von Anspruch 1 oder 2 beansprucht, wobei ein oder mehrere Einsätze (103) auf oder in der strukturierten Fläche (14) des ersten Teils (3) zum Einfügen in den resultierenden gebildeten glashaltigen Gegenstand (51) platziert werden.

4. Verfahren wie in einem der Ansprüche 1 - 3 beansprucht, wobei die zweite Fläche (12) eben oder strukturiert ist.

5. Verfahren wie in einem der Ansprüche 1 - 4 beansprucht, wobei entweder das Substrat (100) oder mindestens einer des einen oder der mehreren Formeinsätze (102; 103) ein Material mit einer Wärmeleitfähigkeit umfasst, die höher als die des Glases der glashaltigen Zusammensetzung (2) ist.

6. Verfahren wie in einem der Ansprüche 1 - 5 beansprucht, wobei entweder das Substrat (100) oder mindestens einer des einen oder der mehreren Formeinsätze (102; 103) eines oder mehrere von Keramik, Silizium, Siliziumverbindungen und Metall umfasst.

7. Verfahren wie in einem der Ansprüche 1 - 6 beansprucht, wobei entweder das Substrat (100) oder mindestens einer des einen oder der mehreren Formeinsätze (102; 103) Aluminiumoxid umfasst.

8. Verfahren wie in einem der Ansprüche 1 - 7 beansprucht, wobei das erste Teil (3; 62; 81) aus dem steifen Antihaftmaterial Kohlenstoff umfasst.

9. Verfahren wie in einem der Ansprüche 1 - 8 beansprucht, wobei das erste Teil (3; 62; 81) aus dem steifen Antihaftmaterial ein poröses Material mit einer Offenporigkeit von mindestens 5 %, sogar mindestens 10 % umfasst.

10. Verfahren nach einem der Ansprüche 1 - 9, wobei die glashaltige Zusammensetzung (2; 60; 81) aus einem oder mehreren porzellanartigen Gläsern besteht oder eine Glaskeramik umfasst.

11. Verfahren nach einem der Ansprüche 1 - 9, wobei die glashaltige Zusammensetzung (2; 60; 81) ein gefülltes Glas umfasst, das ein Glas und mindestens einen Füllstoff umfasst, und wobei der mindestens eine Füllstoff eine höhere Wärmeleitfähigkeit als das Glas aufweist.

12. Verfahren nach Anspruch 11, wobei der Füllstoff Aluminiumoxid ist.

13. Verfahren nach einem der Ansprüche 1 -12, wobei der Schritt des Bereitstellens einer ersten Menge der glashaltigen Zusammensetzung (2; 60; 81) ein Bereitstellen der glashaltigen Zusammensetzung in der Form einer Platte umfasst.

14. Verfahren nach einem der Ansprüche 1 -12, wobei der Schritt des Bereitstellens einer ersten Menge der glashaltigen Zusammensetzung ein Bereitstellen der glashaltigen Zusammensetzung in der Form einer Fritte oder einer verfestigten Frittenschicht umfasst.

15. Verfahren nach einem der Ansprüche 1 -14, wobei der Schritt des Abdichtens ein Stapeln des ersten gebildeten glashaltigen Gegenstands (91) mit einem oder mehreren zusätzlichen glashaltigen Gegenständen oder glashaltigen Formgegenständen (93; 95; 97; 99) und ein gemeinsames Abdichten der gestapelten Gegenstände umfasst.

16. Verfahren nach einem der Ansprüche 1 -15, ferner umfassend den Schritt eines Anordnens eines Trennmittels zwischen der ersten Menge der glashaltigen Zusammensetzung (2; 60; 81) und der strukturierten Fläche (14).

## Revendications

1. Procédé de formation d'un dispositif microfluidique contenant du verre et comportant au moins un passage de fluide au travers, le procédé comprenant :
la fourniture d'une première pièce (3 ; 62 ; 82) ayant une surface de moulage à motifs (14) ;
la fourniture d'une première quantité de composition contenant du verre (2 ; 60 ; 81) ;
la mise en contact de la première quantité de composition contenant du verre (2 ; 60 ; 81) avec la surface de moulage à motifs (14) ;
le pressage de la première quantité de composition contenant du verre (2 ; 60 ; 81) entre la surface de moulage à motifs (14) et une seconde surface (12) ;
le chauffage conjoint de la première pièce (3 ; 62 ; 82) et de la première quantité de composition contenant du verre (2 ; 60 ; 81), suffisamment pour ramollir la quantité de composition contenant du verre (2 ; 60 ; 81) de telle sorte que la surface de moulage à motifs (14) est répliquée dans la première quantité de composition contenant du verre (2 ; 60 ; 81), la première quantité de composition contenant du verre (2 ; 60 ; 81) formant un premier article contenant du verre formé (51 ; 63 ; 91) ;
le scellement d'au moins une partie du premier article contenant du verre formé (51 ; 63 ; 91) pour créer un dispositif microfluidique ayant au moins un passage fluidique au travers ;
**caractérisé en ce que** ladite première pièce (3 ; 62 ; 82) est constituée d'un matériau rigide non collant, **en ce que** l'étape de chauffage conjoint comprend le chauffage à une température suffisante pour produire du verre fondu et entraîner un écoulement visqueux de la composition contenant du verre (2 ; 60 ; 81) et **en ce que** la seconde surface (12) comprend une surface d'un substrat (100) sur lequel la composition contenant du verre (2) doit être formée, ladite étape de chauffage étant efficace pour attacher ou assembler la composition contenant du verre (2) à la surface (12) du substrat (100).

2. Procédé selon la revendication 1, dans lequel la seconde surface (12) comprend en outre une ou plusieurs surfaces d'une ou plusieurs inserts de moule (102) placées sur ledit substrat (100), pour incorporation dans l'article contenant du verre formé (51) résultant.

3. Procédé selon l'une ou l'autre de la revendication 1 et de la revendication 2, dans lequel une ou plusieurs inserts (103) sont placées sur ou dans la surface à motifs (14) d'une première pièce (3), pour incorporation dans l'article contenant du verre formé (51) résultant.

4. Procédé selon l'une quelconque des revendications 1 à 3, dans lequel la seconde surface (12) est plate ou à motifs.

5. Procédé selon l'une quelconque des revendications 1 à 4, dans lequel l'un ou l'autre du substrat (100) ou d'au moins une des une ou plusieurs inserts de moule (102 ; 103) comprend un matériau ayant une conductivité thermique plus élevée que celle du verre ou de la composition contenant du verre (2).

6. Procédé selon l'une quelconque des revendications 1 à 5, dans lequel l'un ou l'autre du substrat (100) ou d'au moins une des une ou plusieurs inserts de moule (102 ; 103) comprend un ou plusieurs parmi céramique, silicium, composés de silicium et métal.

7. Procédé selon l'une quelconque des revendications 1 à 6, dans lequel l'un ou l'autre du substrat (100) ou d'au moins une des une ou plusieurs inserts de moule (102 ; 103) comprend de l'alumine.

8. Procédé selon l'une quelconque des revendications 1 à 7, dans lequel la première pièce (3 ; 62 ; 82) en matériau rigide non collant comprend du carbone.

9. Procédé selon l'une quelconque des revendications 1 à 8, dans lequel la première pièce (3 ; 62 ; 82) en matériau rigide non collant comprend un matériau poreux avec une porosité ouverte d'au moins 5 %, et même d'au moins 10 %.

10. Procédé selon l'une quelconque des revendications 1 à 9, dans lequel la composition contenant du verre (2 ; 60 ; 81) est constituée d'un ou de plusieurs verres vitreux ou comprend une vitrocéramique.

11. Procédé selon l'une quelconque des revendications 1 à 9, dans lequel la composition contenant du verre (2 ; 60 ; 81) comprend un verre chargé comprenant un verre et au moins une charge, et dans lequel l'au moins une charge a une conductivité thermique plus élevée que le verre.

12. Procédé selon la revendication 11, dans lequel la charge est de l'alumine.

13. Procédé selon l'une quelconque des revendications 1 à 12, dans lequel l'étape de fourniture d'une première quantité de composition contenant du verre (2 ; 60 ; 81) comprend la fourniture de la composition contenant du verre sous la forme d'une feuille.

14. Procédé selon l'une quelconque des revendications 1 à 12, dans lequel l'étape de fourniture d'une première quantité de composition contenant du verre comprend la fourniture de la composition contenant du verre sous la forme d'une couche de fritte ou de fritte consolidée.

15. Procédé selon l'une quelconque des revendications 1 à 14, dans lequel l'étape de scellement comprend l'empilement du premier article contenant du verre formé (91) avec un ou plusieurs articles contenant du verre ou articles contenant du verre formé (93 ; 95 ; 97 ; 99) additionnels et le scellement des articles empilés ensemble.

16. Procédé selon l'une quelconque des revendications 1 à 15, comprenant en outre l'étape de positionnement d'un agent anti-adhérent entre la première quantité de composition contenant du verre (2 ; 60 ; 81) et la surface à motifs (14).
